# EUROPÄISCHE PATENTANMELDUNG

(11) **EP 1 691 412 A2**
(43) Veröffentlichungstag der Anmeldung: **16.08.2006**
(21) Anmeldenummer: 06405036.2
(22) Anmeldetag: 26.01.2006
(51) Int. Cl.: H01L 23/367, H01L 21/48

(54) **Kühlkörper für Halbleiterbauelemente, sowie Verfahren zu dessen Herstellung**

(30) Priorität: 15.02.2005 DE 102005007041
(71) Anmelder: Alcan Technology & Management Ltd., 8212 Neuhausen am Rheinfall (CH)
(72) Erfinder: Bock, Stephan, 78224 Singen (DE); Bock, Uwe, 78224 Singen (DE)

(57) **Zusammenfassung**

Die Erfindung betrifft einen Kühlkörper (10) für Halbleiterbauelemente oder dgl. Einrichtungen, mit in Abstand zueinander von einer Sockelplatte (12) aus einer stranggepressten Aluminiumlegierung als Basisteil aufragenden Kühlrippen (20, 20ₐ, 40), die jeweils mit einem Ende, gegebenenfalls mit einem querschnittlich etwa rechteckigen Kupplungssockel (24), als Verbindungspartner für eine in die Oberfläche der Sockelplatte (12) eingebrachte Einsatznut (14, 14ₐ) von diese seitlich begrenzenden Längs- oder Zwischenrippen (16) klemmend gehalten sind, wobei die zum anderen Verbindungspartner (14, 20ₐ) weisenden Flächen des einen Verbindungspartners (14ₐ, 20) querschnittlich sägezahnartig ausgebildet sind sowie zwischen Rippen (26, 26ₐ) verlaufende Längseinformungen (28, 28ₐ) aufweisen. Erfindungsgemäß ist dabei vorgesehen, dass die Kühlrippen (20, 20ₐ, 40) formschlüssig in ihren Einsatznuten (14, 14ₐ) gehalten und zumindest abschnittsweise mit der Sockelplatte (12) durch einen Kunststoff (30) niedriger Viskosität, insbesondere einem Kunstharz, verbunden sind.

## Beschreibung

Die Erfindung betrifft einen Kühlkörper für Halbleiterbauelemente oder dgl. Einrichtungen mit in Abstand zueinander von einer Sockelplatte aus einer stranggepressten Aluminiumlegierung als Basisteil aufragenden Kühlrippen, die jeweils mit einem Ende -- gegebenenfalls mit einem querschnittlich etwa rechteckigen Kupplungssockel -- als Verbindungspartner für eine in die Oberfläche der Sockelplatte eingebrachte Einsatznut von -- diese seitlich begrenzenden -- Längs- oder Zwischenrippen klemmend gehalten sind; die zum anderen Verbindungspartner weisenden Flächen des einen Verbindungspartners sind querschnittlich sägezahnartig ausgebildet und weisen zwischen Rippen verlaufende Längseinformungen auf. Zudem erfasst die Erfindung ein Verfahren zum Herstellen eines solchen Kühlkörpers.

Kühlkörper dieser Art sind der DE 35 18 310 A1 zu entnehmen; nach deren Lehre werden stranggepreßte Vollprofile mit seitlichen Ausformungen als Kühlrippen in die Einsatznuten der gesondert erzeugten Sockelplatte formschlüssig eingesetzt. Die Nutwände der Einsatznut werden nach dem Einbringen der Kühlrippe durch ein -- zwischen zwei Kühlrippen einfahrbares -- keilartig ausgebildetes Werkzeug verformt, das dazu in eine Hilfsnut V-förmigen Querschnitts eingesetzt wird und teilweise den Werkstoff des Gehäusesockels in Parallelnuten der Kühlrippe drückt.

Die DE 25 02 472 A1 zeigt an einem Kühlkörper für Thyristoren sich konisch zum Nutengrund hin verjüngende Einsatznuten der Basisgehäuseplatte für die Kühlrippen. Diese werden mit Übermaß in die -- mit Längsnuten in den beiden Seitenwänden versehenen -- Einsatznuten eingepresst. Während in diesem Falle eine Mindestdicke der Rippe erforderlich ist, um die notwendigen Druckkräfte beim Fügeverfahren aufnehmen zu können, ist bei einem Verfahren nach DE 35 18 310 A1 nur ein formschlüssiger Verbund erreichbar. In beiden Fällen ist die einsetzbare Rippenzahl -- und damit die erreichbare Wärme abführende Oberfläche -- einerseits durch die erforderliche Mindestdicke der Kühlrippen sowie andererseits durch die notwendige Mindestbreite der Zwischennuten begrenzt.

Um eine bessere Kühlleistung zu erreichen, werden häufig Kühlkörper aus separat gefertigten Rippen und Basisteilen zusammengefügt. In der Regel werden hierfür artgleiche Werkstoffe wie Aluminium und seine Legierungen verwendet. Die Rippen werden durch spezielle Fügeverfahren der Basis- oder Sockelplatte verbunden. Aus den verschiedensten technischen Gründen bestehen Zwänge, Kühlkörper dieser Art "in die Höhe" zu bauen. Dies führt jedoch zu einer wärmetechnisch geringen Effektivität, bedingt durch einen relativ schlechten Rippenwirkungsgrad; eine große Rippenhöhe ist auch nicht -- wegen der dann zu reduzierenden Rippenanzahl -- über eine vergrößerte Rippendicke zu kompensieren.

In Kenntnis dieser Gegebenheiten hat sich der Erfinder die Aufgabe gestellt, einen neuen Kühlkörper sowie ein neues Fertigungsverfahren zu entwickeln, dank deren das Temperaturverhalten verbessert zu werden vermag.

Zur Lösung dieser Aufgabe führt die Lehre des unabhängigen Anspruches; die Unteransprüche geben günstige Weiterbildungen an. Zudem fallen in den Rahmen der Erfindung alle Kombinationen aus zumindest zwei der in der Beschreibung, der Zeichnung und/oder den Ansprüchen offenbarten Merkmale.

Eine Lösung könnten Rippen aus einem Werkstoff höherer Wärmeleitfähigkeit -- wie Kupfer oder Kohlenstoff -- bieten. Aufgrund der erheblichen elektrischen Potentialunterschiede ist bei direktem metallischem Kontakt eine starke Korrosionsgefahr gegeben. Die Methode des Verklebens der Verbindungspartner führt zu einem verhältnismäßig schlechten Wärmeübergang.

Erfindungsgemäß werden die Kühlrippen formschlüssig in ihren Einsatznuten gehalten und sind zumindest abschnittsweise mit der Sockelplatte durch einen Kunststoff -- insbesondere ein Kunstharz -- niedriger Viskosität verbunden. Die Rippen des einen Verbindungspartners sollen den benachbarten Flächen des anderen Verbindungspartners anliegen und die voneinander getrennten Längseinformungen mit dem Kunststoff -- vor allem einem Zweikomponenten-Kunststoff -- versehen sein, der bevorzugt einen Härter und einen Binder enthält.

Nach einem anderen Merkmal der Erfindung, enthält der Kunststoff metallische Partikel mit hohem Wärmeleitwert.

Bevorzugt sind alle Kühlrippen aus einem Halbedelmetall geformt, z.B. aus einem Kupferwerkstoff. Es hat sich darüber hinaus gezeigt, dass sich ein Kühlkörper insbesondere auf das zu kühlende Bauteil speziell auslegen lässt. Als günstig hat es sich deshalb erwiesen, dass ein Teil der Kühlrippen aus einer Leichtmetalllegierung und ein anderer Teil der Kühlrippen aus einem Halbedelmetall geformt sind, vor allem aus einem Werkstoff der Kupfergruppe. Dabei soll weniger als ein Drittel der Kühlrippen aus Kupferwerkstoff bestehen. Zudem soll der Zweikomponentenkunststoff Kupferpartikel enthalten.

Im Rahmen der Erfindung liegt ein Verfahren zum Herstellen eines Kühlkörpers durch Einsetzen von Kühlrippen in eine Sockelplatte mit Zwischenrippen, bei dem vor dem Einsetzen der Kühlrippe deren als Verbindungspartner dienender, mit Rippen versehener Bereich mit einer Schicht aus einem Kunststoff bedeckt wird.

Nach dem Aufbringen des Kunststoffes werden die Flanken der Längseinformungen verformt, und der Kunststoff kann, muss aber nicht von den Zahnspitzen verdrängt werden. Auf diese Weise ist neben einer weiterhin durch den Kunststoff gegebenen guten Wärmeleitfähigkeit auch sichergesellt, dass eine Korrosion in den andernfalls ohne Kunststoff offenen Längseinformungen, sicher unterbunden ist.

Die Gefahr einer Korrosion wäre nämlich gerade aufgrund des Potenzialunterschieds benachbarter Metalle in Anwesenheit eines Elektrolyts, wie z. B. Wasser oder Feuchtigkeit, besonders hoch. Gemäß der Erfindung dient der Kunststoff somit vorteilhaft auch als Oberflächenversiegelung und zum Schließen der Längseinformungen

Weitere Vorteile, Merkmale und Einzelheiten der Erfindung ergeben sich aus der nachfolgenden Beschreibung bevorzugter Ausführungsbeispiele sowie anhand der Zeichnung; diese zeigt in:
- Fig. 1:: die Frontansicht eines Kühlkörpers mit von einem Gehäusesockel aufragenden Kühlrippen;
- Fig. 2:: einen vergrößerten Teil des Gehäusesockels der Fig. 1;
- Fig. 3, 4:: jeweils einen vergrößerten Ausschnitt aus Fig. 1 zu zwei unterschiedlichen Ausgestaltungen des Gehäusesockels sowie der Kühlrippen;
- Fig. 5,6,7:: gegenüber den Fig. 3, 4 vergrößerte Teilausschnitte zu verschiedenen Ausgestaltungen des Kühlkörpers;
- Fig. 8:: die Ansicht einer dreiarmigen Kühlrippe aus der Perspektive einer Seitenansicht für einen Kühlkörper.

Ein Kühlkörper 10 für Halbleiterbauelemente weist ein in der Zeichnung aus Gründen der Übersichtlichkeit nicht weiter dargestelltes Gehäuse mit einer Sockelplatte als Gehäusesockel 12 einer beispielsweisen Breite a von etwa 202 mm und einer Dicke b von hier etwa 23,5 mm auf.

In die Sockelplatte 12 sind -- hier sechsunddreißig -- parallel zueinander verlaufende Einsatznuten 14 etwa rechteckigen Querschnitts einer Breite c von etwa 1,7 mm und einer Tiefe f von etwa 4 mm eingeformt, die durch Längs- oder Zwischenrippen 16 ebenfalls rechteckigen Querschnitts einer -- gegenüber den Einsatz- oder Bodennuten 14 etwas größeren -- Breite g von etwa 3,8 mm voneinander getrennt sind. Der Mittenabstand e zweier Einsatznuten 14 misst hier etwa 5,5 mm. In die Firstfläche jeder Zwischenrippe 16 ist eine querschnittlich V-artige Zwischennut 18 von oben her eingeformt.

In den Einsatznuten 14 sind in einem lichten Abstand z zueinander parallel verlaufende Kühlrippen 20 einer Breite i von 1,5 mm festgelegt. Gehäusesockel bzw. Sockelplatte 12 und Kühlrippen 20 werden getrennt auf dem Wege des Strangpressens aus Metall -- insbesondere aus Aluminiumlegierungen -- hergestellt und anschließend zusammengefügt.

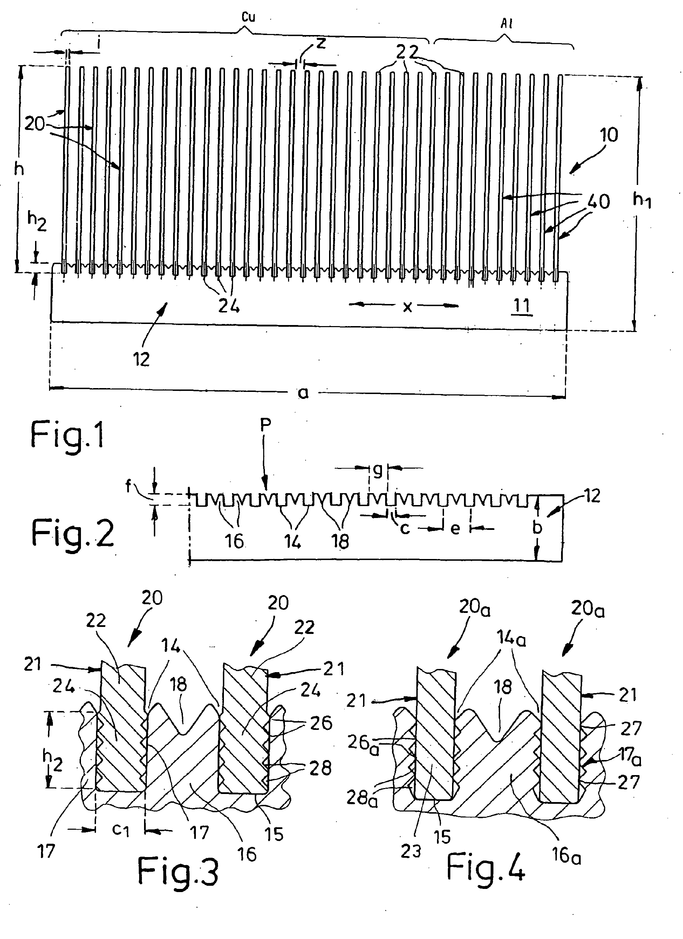

In Fig. 1 ist in dessen Firstbereich angedeutet, dass nur ein Teil der Kühlrippen 20 aus Leichtmetall gefertigt sind, ein anderer Teil enthält Kühlrippen aus einem Material mit hohem Wärmeleitwert, insbesondere Kupferwerkstoff oder aus Graphit, die der besseren Übersicht halber mit 40 gekennzeichnet sind. Das Gewicht des Kühlkörpers 10 der Fig. 1 setzt sich aus dem Sockelgewicht von 11,884 kg/m sowie dem Rippengehalt von 0,328 kg/m zusammen, beträgt also 23,692 kg/m .

Da im Falle der unterschiedlichen Metalle bei den Rippen 20, 40 unterschiedliche Ausdehnungskoeffizienten entstehen, werden die Kühlrippen 20, 40 in ihrer Längsersteckung unterteilt, beispielsweise durch ein in Pfeilrichtung der Fig. 1 geführtes -- nicht gezeigtes - Sägeblatt, das in Abstand zur Längsseite 11 des Gehäusesockels 12 durch die Kühlrippen 20, 40 geführt wird.

Es hat sich gezeigt, dass sich eine Kühlleistung des Kühlkörpers auch dadurch verbessern lässt, dass Mittel zur Erzeugung eines gewissen Turbulenzanteils bei der die Rippen durchsetzenden Luftströmung an einer Kühlrippe des Kühlkörpers vorgesehen sind. Zweckmäßigerweise kann eine Kühlrippe dazu eine oder mehrere Ausnehmungen aufweisen. Eine solche Ausnehmung lässt sich z.B. als ein mittiges eingestanztes Längsloch an der Kühlrippe bilden. Weiter ist es auch möglich eine Kühlrippe z. B. entlang ihrer Länge, durch zumindest einen Einschnitt zu unterbrechen.

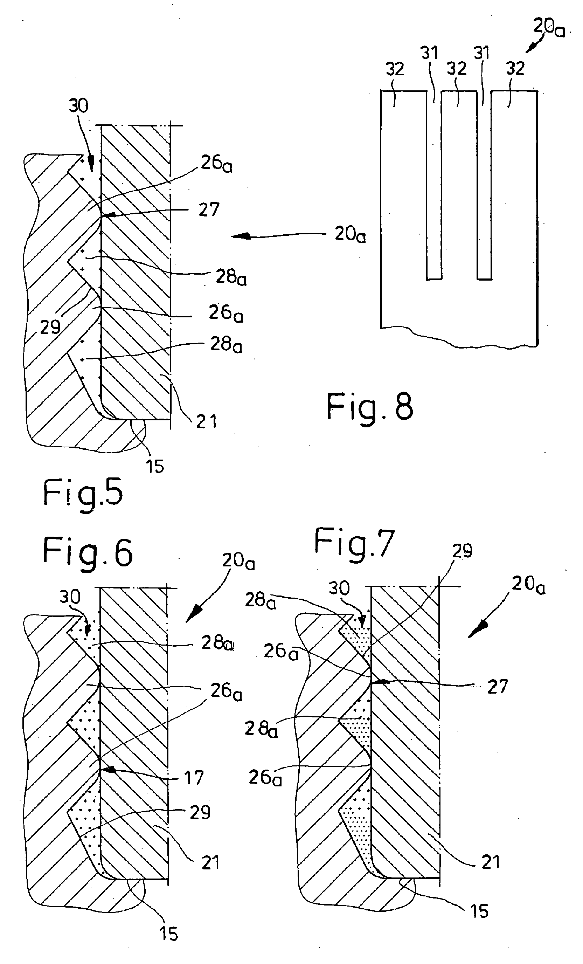

Fig. 8 zeigt eine bevorzugte Ausführungsform einer dreiarmigen Kühlrippe 20ₐ mit zwei Längseinschnitten 31. Die Arme 32 können eine gleiche oder eine unterschiedliche Breite haben. Ein solcher Einschnitt 31 kann nach unten oder wie gezeigt, oben offen sein - er lässt sich dann vorteilhaft sägen. In einer weiteren zweckmäßigen Ausführungsform ist eine Kühlrippe zwei- oder mehrteilig durch entsprechende längliche Teilrippen gebildet, die auch getrennt in den Sockel 12 eingesetzt werden können.

Die Kühlrippe 20 der Länge h von etwa 81 mm -- die eine Gesamthöhe h₁ des Kühlkörpers 10 von 100,5 mm vorgibt -- besteht in Fig. 1, 3 aus einem in Einbaulage frei aufragenden -- zwei ebene Seitenflächen 21 anbietenden -- plattenartigen Rippenkörper 22 sowie einem angeformten Kupplungssockel 24 der Höhe h₂ von 4 mm, dessen Querschnitt etwa jenem der Einsatznuten 14 entspricht; in Fig. 3 ist die Sockelbreite mit c₁ gekennzeichnet. In die beiden freien Seitenflächen des Kupplungssockels 24 jeder Kühlrippe 20 sind hierdurch zur Sockeloberfläche parallele Rippen 26 getrennteLängseinformungen 28 so eingeformt, dass die Rippen 26 der einen Seitenfläche den Rippen 26 der anderen Seitenfläche -- und damit auch die Längseinformungen 28 in den Seitenflächen -- gegenüberstehen.

Der Kupplungssockel 24 wird in die Einsatznut 14 der Sockelplatte 12 eingeschoben, bis er dem Nutentiefsten 15 aufsitzt. Zur besseren Lagesicherung zwischen den ebenen Nutwänden 17 benachbarter Zwischenrippen 16 ist -- wie Fig. 3 zeigt -- jede Flankenfläche des Kupplungssockels 24 mit querschnittlich eine sägezahnartige Anordnung ergebenden Rippen 26 sowie Längseinformungen 28 versehen.

Nach dem Einsetzen des Kupplungssockels 24 in die Einsatznut 14 wird in die Zwischennut 18 der Zwischenrippe 16 ein hier nicht dargestelltes plattenähnliches -- in Pfeilrichtung P der Fig. 2 druckbelastetes -- Fügewerkzeug aufgesetzt, dessen jener Zwischennut 18 zugekehrter Bodenrand mit einer zinnenartigen Reihe von Zähnen ausgestattet sein kann und in die Zwischennut 18 eingesetzt wird.

Bei der Ausgestaltung nach Fig. 4 ist die Kühlrippe 20ₐ ohne besondere Ausbildung eines Kupplungssockels am freien Rippenende 23 in die Einsatznut 14ₐ bis zum Nutentiefstens 15 eingeschoben, deren Seitenflächen 17ₐ Längseinformungen 28ₐ zwischen Rippen 26ₐ aufweisen. Die Zahnspitzen oder Endgrate 27 der Rippen 26ₐ liegen den glatten Seitenflächen 21 der Kühlrippe 20ₐ an.

Die Einsatznuten 14ₐ bzw. der Kupplungssockel 24 werden also querschnittlich etwa sägezahnförmig gestaltet und die stranggepresste Sockelplatte 12 zwischen den Einsatznuten 14, 14ₐ zusätzlich mit den V-förmigen Zwischennuten 18 ausgestattet. Letztere dienen dabei zur Führung des beschriebenen Fügewerkzeuges. Vor dem Einbringen in die Einsatznuten 14, 14ₐ werden die Kupplungssockel 24 oder die freien Rippenenden 23 mit einem Kunstharz 30 niedriger Viskosität benetzt.

Das erwähnte Kunstharz 30 weist zwei Komponenten auf: Härter und Binder, und es kann mit Partikeln aus Kupfer oder anderem Halbedelmetall gemischt sein. Es hat sich gezeigt, dass eine für die Fertigung günstige Zusammensetzung zur Bildung des Kunstharzes 30 im wesentlichen ein Gemisch aus einem unter dem Vertriebsnamen Araldite 2012 bekannten Härter und einem unter dem Vertriebsnamen Araldite AW 106 bekannten Binder aufweist. Dabei lässt sich im Hinblick auf die Anwendung und die für die Verarbeitung zweckmäßige Viskosität unter anderem das Mischungsverhältnis beider Komponenten einstellen. Die beiden oben genannten beispielhaften Komponenten lassen sich insbesondere anwendungsbezogen modifizieren, ergänzen oder durch andere Komponenten ähnlicher Beschaffenheit ersetzen. Insbesondere wird das Gemisch aus weiter unten genannten Gründen vorzugsweise mit Partikeln aus hochwärmeleitfähigem Material, wie Graphit oder einem Halbedelmetall, z. B. Kupfer versetzt.

Nach oder während dem Einlegen der Kühlrippen 20, z.B. durch Einrammen derselben, werden die Flanken der Zwischennuten 18 so verformt, dass das Kunstharz 30 aufgrund geringer Viskosität im Bereich der Zahnspitzen 27 völlig verdrängt wird, so dass dort ein metallischer Kontakt gegeben ist (wie Fig. 5 andeutet). Gemäß dem Konzept der Erfindung ist gewährleistet, dass die auf diese Weise entstandenen Kontaktbahnen durch das Kunstharz 30 derart gegen aggressive Medien abgeschirmt sind, dass eine Korrosionsgefahr weitgehend ausgeschlossen werden kann. Um zusätzlich einen verbesserten Wärmeübergang zu erreichen, sind in das Kunstharz metallische Partikel mit hohem Wärmeleitwert eingelagert. Schwerkraftbedingt werden diese Partikel noch vor dem Aushärten im Kunstharz 30 geringer Viskosität in den Längseinformungen oder Zahnlücken 28 zur unteren Wandfläche 29 absinken und damit zu Bahnen mit hohem metallischem Anteil sowie noch weiter verbesserter Wärmeleitfähigkeit führen.

In Fig. 6 beginnt sich das Kunstharz 30 langsam zu verdichten und die Partikel setzen sich gemäß der in Fig. 7 gezeigten dichteren Punktierung an der unteren Wandfläche 27 der Längseinformung 28ₐ ab.

## Patentansprüche

1. Kühlkörper (10) für Halbleiterbauelemente oder dgl. Einrichtungen, mit in Abstand zueinander von einer Sockelplatte (12) aus einer stranggepressten Aluminiumlegierung als Basisteil aufragenden Kühlrippen (20, 20ₐ, 40), die jeweils mit einem Ende, gegebenenfalls mit einem querschnittlich etwa rechteckigen Kupplungssockel (24), als Verbindungspartner für eine in die Oberfläche der Sockelplatte (12) eingebrachte Einsatznut (14, 14ₐ) von diese seitlich begrenzenden Längs- oder Zwischenrippen (16) klemmend gehalten sind, wobei die zum anderen Verbindungspartner (14, 20ₐ) weisenden Flächen des einen Verbindungspartners (14ₐ, 20) querschnittlich sägezahnartig ausgebildet sind sowie zwischen Rippen (26, 26ₐ) verlaufende Längseinformungen (28, 28ₐ) aufweisen,
**dadurch gekennzeichnet,**
**dass** die Kühlrippen (20, 20ₐ, 40) formschlüssig in ihren Einsatznuten (14, 14ₐ) gehalten und zumindest abschnittsweise mit der Sockelplatte (12) durch einen Kunststoff (30) niedriger Viskosität, insbesondere einem Kunstharz, verbunden sind.

2. Kühlkörper nach Anspruch 1, **dadurch gekennzeichnet, dass** die Rippen (26, 26ₐ) des einen Verbindungspartners (14ₐ, 20) den benachbarten Flächen (17, 21) des anderen Verbindungspartners (14ₐ, 20) anliegen und die voneinander getrennten Längseinformungen (28, 28ₐ) mit dem Kunststoff (30) versehen sind.

3. Kühlkörper nach Anspruch 1 oder 2, **dadurch gekennzeichnet, dass** der Kunststoff in Form eines Zweikomponenten-Kunststoffs (30) gebildet ist.

4. Kühlkörper nach Anspruch 3, **dadurch gekennzeichnet, dass** der Zweikomponenten-Kunststoff (30) einen Härter und einen Binder enthält.

5. Kühlkörper nach einem der Ansprüche 1 bis 4, **dadurch gekennzeichnet, dass** der Kunststoff (30) metallische Partikel mit hohem Wärmeleitwert enthält.

6. Kühlkörper nach Anspruch 5, **dadurch gekennzeichnet, dass** die metallischen Partikel in Form von Kupferpartikeln gebildet sind.

7. Kühlkörper nach einem der Ansprüche 1 bis 6, **dadurch gekennzeichnet, dass** ein Teil (A1) der Kühlrippen (20) aus einer Leichtmetalllegierung und ein anderer Teil (Cu) der Kühlrippen (40) aus einem Halbedelmetall geformt sind.

8. Kühlkörper nach Anspruch 7, **dadurch gekennzeichnet, dass** das Halbedelmetall durch einen Werkstoff der Kupfergruppe gebildet ist.

9. Kühlkörper nach Anspruch 7 oder 8, **dadurch gekennzeichnet, dass**, als der andere Teil (Cu), weniger als ein Drittel der Kühlrippen (40) aus Kupferwerkstoff besteht.

10. Kühlkörper nach einem der Ansprüche 1 bis 9, **dadurch gekennzeichnet, dass** eine Kühlrippe (20) entlang ihrer Länge durch zumindest einen Einschnitt unterbrochen ist.

11. Kühlkörper nach Anspruch 10, **dadurch gekennzeichnet, dass** der zumindest eine Einschnitt zur Sockelplatte hin offen ist.

12. Kühlkörper nach Anspruch 10, **dadurch gekennzeichnet, dass** der zumindest eine Einschnitt in Form eines durchgehenden Spalts gebildet ist, der eine Kühlrippe (20) in wenigstens zwei separate Teilrippen teilt.

13. Verfahren zum Herstellen eines Kühlkörpers durch Einsetzen von Kühlrippen in eine Sockelplatte mit Zwischenrippen, nach einem der voraufgehenden Ansprüche, **dadurch gekennzeichnet, dass** vor dem Einsetzen der Kühlrippe deren als Verbindungspartner dienender, mit Rippen versehener Bereich mit einer Schicht aus einem Kunststoff bedeckt wird.

14. Verfahren nach Anspruch 13, **dadurch gekennzeichnet, dass** die voneinander getrennten Längseinformungen der Rippen mit dem Kunststoff versehen werden.

15. Verfahren nach Anspruch 13 oder 14, **dadurch gekennzeichnet, dass** der Kunststoff in Form eines Zweikomponenten-Kunststoffs gebildet wird.

16. Verfahren nach einem der Ansprüche 13 bis 15, **dadurch gekennzeichnet, dass** nach dem Aufbringen des Kunststoffes die Flanken der Längseinformungen verformt und der Kunststoff von den Zahnspitzen verdrängt wird.
